# EUROPEAN PATENT SPECIFICATION

(11) **EP 1 923 744 B1**
(45) Date of publication and mention of the grant of the patent: **18.09.2013**
(21) Application number: 07121119.7
(22) Date of filing: 20.11.2007
(51) Int. Cl.: G03F 7/20, G03F 9/00

(54) **Immersion exposure apparatus and exposure method**
Immersionsbelichtungsgerät und Belichtungsverfahren
Appareil d'exposition par immersion et procédé d'exposition

(30) Priority: 20.11.2006 JP 2006312928
(43) Date of publication of application: 21.05.2008
(73) Proprietor: Canon Kabushiki Kaisha, Ohta-Ku, Tokyo 146-8501 (JP)
(72) Inventor: Emoto, Keiji, Tokyo (JP)
(74) Representative: Hitching, Peter Matthew

(56) References cited:
- EP-A1- 1 713 113
- EP-A1- 1 933 371
- EP-A2- 1 921 504

## Description

### BACKGROUND OF THE INVENTION

### Field of the Invention

The present invention relates to an immersion exposure apparatus that exposes a substrate through a projection optical system and liquid while the space between the surface of the final lens of the projection optical system and the surface of the substrate is filled with the liquid.

### Description of the Related Art

Projection exposure apparatus for projecting a circuit pattern drawn on a reticle (mask) onto a substrate or the like through a projection optical system has been commonly used, and there have recently been increasing demands for high-resolution, economic projection exposure apparatus. Accordingly, immersion exposure has been attracting attention as a means for satisfying the demands for higher resolution. In an immersion exposure operation, a liquid is used as a medium interposed between the projection optical system and the substrate, so that the numerical aperture (NA) of the projection optical system can be increased. The NA of the projection optical system is expressed as NA = n·sinθ, where n is a refractive index of the medium. Therefore, the NA can be increased by n by filling the space between the projection optical system and the substrate with medium having a refractive index higher than that of air (i.e. n > 1). According to the immersion exposure operation, the NA is increased as described above so that the resolution R expressed as R = k1(λ/NA), where k1 is a process coefficient and λ is the wavelength of the light source, can be reduced (i.e., high-resolution apparatus can be obtained).

As an example of an immersion exposure method, Domestic Republication of PCT International Publication No. WO99/49504 discusses a local fill method in which a light-path space between a surface of the final lens in the projection optical system and a surface of the substrate is locally filled with liquid. However, in the local fill method, since the liquid is circulated in a small space between the surface of the final lens in the projection optical system and the surface of the substrate, there is a risk that the liquid cannot be smoothly supplied and recovered. More specifically, supply and recovery of the liquid may become unbalanced when a stage is moved. In such a case, the following phenomena will occur.
(1) The liquid cannot be completely retained in the space below the final lens and some liquid will spill out of the space and remain on the substrate or on a measurement sensor mounted on the stage.
(2) The membrane interface of the liquid will become unstable and air bubbles will be mixed into the liquid.

In the case of item (1), if the liquid remains on the substrate, there is a risk that exposure defects will occur due to problems in the process. If the liquid remains on the measurement sensor, measurement errors will occur, which leads to a reduction in the exposure accuracy. In the case of item (2), characteristics of the projection optical system will be degraded. This also leads to a reduction in the exposure accuracy and exposure defects. Both problems will reduce process yield.

To solve these problems, Japanese Patent Laid-Open No. 2004-289126 discusses a method of sealing the liquid interposed between the surface of the final lens in the projection optical system and the surface of the substrate by surrounding the liquid with gas. According to this method, the occurrence of the situation in which some of the liquid cannot be retained in the space between the surface of the final lens in the projection optical system and the surface of the substrate and spills out of the space can be reduced.

On the other hand, International Publication No. 2005/074014 discusses a system including an immersion exposure apparatus using the local fill method in which two independent stages for positioning respective substrates are placed below a final lens of a projection optical system in a switchable manner. In this system, the two stages are moved while being close to each other or in contact with each other so that they can be switched under the final lens of the projection optical system while the liquid is being retained.

However, irrespective of whether or not the technique described in Japanese Patent Laid-Open No. 2004-289126 is applied, the liquid will spill out of the space below the final lens if the substrate is moved by a predetermined distance above a certain velocity. If the velocity is increased, the liquid will remain on the substrate or on the measurement sensor. More specifically, after the stage is moved at the predetermined velocity or more, the liquid will remain on the substrate or on the measurement sensor mounted on the stage. In the following description, a maximum moving velocity of the stage at which the liquid does not spill of the space below the final lens will be referred to as a limit velocity. The limit velocity depends on the moving distance of the substrate. As the moving distance is increased, the limit velocity is reduced. The limit velocity also depends on the liquid repellency of the surface with which the liquid is in contact while the substrate is being moved. As the liquid repellency is reduced, the limit velocity is also reduced. Thus, the limit velocity is a parameter determined by the moving distance and the liquid repellency of the moving surface.

In the immersion exposure apparatus, the moving velocity must always be equal to or less than the limit velocity since retention of the liquid on the bottom surface of the final lens is prioritized. Therefore, moving times required in moving operations are longer than those in exposure apparatuses of a non-immersion type, particularly in certain moving operations. An example of such a moving operation is a moving operation performed immediately before the exposure operation for the first exposure shot area, e.g., an operation of moving to the first exposure shot area after a measurement operation of measuring a reference position is performed. Another example is a moving operation performed immediately after the exposure operation for the last exposure shot area, e.g., a moving operation for switching stages under the bottom surface of the final lens. A still another example is a moving operation performed for measuring various exposure parameters. These moving operations require relatively long moving distances compared to those in the exposure operation (for example between adjacent die on the wafer), and such moving paths pass through regions on the substrate where the liquid repellency is relatively low. Since the moving distances are long, the stage (or the stages) must be moved at a relatively low velocity and long moving times are required. Therefore, the total time required for processing the substrate is increased and the overall throughput of the apparatus is reduced. In view of the above-described situation, it is considered that throughput of immersion exposure apparatuses is more difficult to increase compared to that of exposure apparatuses of a non-immersion type.

In addition, there is another problem in that resist applied to the substrate can have a chemical reaction with the immersion liquid (for example pure water). Therefore, there is a risk that failure will occur in the exposure operation or a development operation. Therefore, the contact area and contact time between the resist on the substrate and the liquid is required to be as small as possible in the exposure operation.

EP 1 713 113 A1 discloses a scanning immersion exposure apparatus disclosing a transition from a first state where one stage (WST1 (or WST2)) is positioned at a first area directly below projection optical system (PL) to which liquid (Lq) is supplied to a state where the other stage (WST2 (or WST1)) is positioned at the first area. Both stages are simultaneously driven while a state where both stages are close together in the X-axis direction is maintained. Therefore, it becomes possible to make a transition from the first state to the second state in a state where liquid is supplied in the space between the projection optical system and the specific stage directly under the projection optical system.

EP 1 921 504 A2, is an intermediate publication, which discloses a liquid immersion exposure apparatus as claimed in the pre-characterizing portion of claims 1 and 5 herein.

EP 1 933 371 A1, is an intermediate publication, which discloses exposure apparatus comprising a liquid immersion system, a first mover, and a prescribed member. The exposure apparatus exposes a substrate via an optical member and a liquid. The liquid immersion system performs supply and recovery of the liquid. The first mover can move in a first area, and can hold the liquid between itself and the optical member. The prescribed member is removed from the first mover when the first mover withdraws from a position opposing the optical member, and can hold the liquid between itself and the optical member.

### SUMMARY OF THE INVENTION

The present invention is directed to an immersion exposure apparatus that can increase the throughput or reduce the occurrence of exposure defects by addressing at least one of the above-described problems.

According to a first aspect of the present invention, there is provided a scanning immersion exposure apparatus as specified in claims 1 to 4.

According to a second aspect of the present invention, there is provided an exposure method using the immersion exposure apparatus as specified in claims 5 and 6.

According to a third aspect of the present invention, there is provided an exposure method as claimed in claim 7.

According to the present invention, the throughput of the immersion exposure apparatus can be increased or the occurrence of exposure defects can be reduced.

Further features of the present invention will become apparent from the following description of exemplary embodiments with reference to the attached drawings.

### BRIEF DESCRIPTION OF THE DRAWINGS

Fig. 1 is a diagram illustrating the overall structure of an immersion exposure apparatus.

Fig. 2 is a diagram illustrating an example of a conventional stage structure.

Fig. 3 is a diagram illustrating a state of the conventional stage structure in a stage-switching operation.

Fig. 4 is a diagram illustrating a locus of an immersion area in the stage structure.

Fig. 5 is another diagram illustrating a locus of the immersion area in the stage structure.

Fig. 6 is a diagram illustrating an example of the order of exposure.

Fig. 7 is a graph illustrating the relationship between the moving distance of the stage, the liquid repellency, and the limit velocity.

Fig. 8 is a diagram illustrating a stage structure according to a first embodiment of the present invention.

Fig. 9 is a diagram illustrating an example of the order of exposure.

Fig. 10 is a diagram illustrating a state of the stage structure according to the first embodiment in a stage-switching operation.

Fig. 11 is a diagram illustrating an example of a state of the stage structure according to the first embodiment.

Fig. 12 is a diagram illustrating another example of the order of exposure.

Fig. 13 is a diagram illustrating another state of the stage structure according to the first embodiment in the stage-switching operation.

Fig. 14 is a diagram illustrating a state of a stage structure according to a second embodiment of the present invention in a stage-switching operation.

Fig. 15 is a diagram illustrating another state of the stage structure according to the second embodiment in the stage-switching operation.

Fig. 16 is a diagram illustrating a state of a stage structure according to a third embodiment of the present invention in a stage-switching operation.

Fig. 17 is a diagram illustrating another state of the stage structure according to the third embodiment in the stage-switching operation.

Fig. 18 is a diagram illustrating a state of a stage structure according to a fourth embodiment of the present invention in a stage-switching operation.

Fig. 19 is a diagram illustrating another state of the stage structure according to the fourth embodiment in the stage-switching operation.

Fig. 20 is a diagram illustrating the side of the stage structure according to the fourth embodiment.

Fig. 21 is another diagram illustrating the side of the stage structure according to the fourth embodiment.

Fig. 22 is a diagram illustrating a state of a stage structure according to a fifth embodiment of the present invention in a stage-switching operation.

Fig. 23 is a diagram illustrating an example of example of the order of exposure.

Fig. 24 is another diagram illustrating a locus of an immersion area in the stage structure according to the fifth embodiment.

Fig. 25 is a diagram illustrating a locus of an immersion area in a stage structure according to a sixth embodiment of the present invention.

Fig. 26 is another diagram illustrating a locus of an immersion area in the stage structure according to the sixth embodiment.

Fig. 27 is a diagram illustrating a locus of an immersion area in a stage structure according to an seventh embodiment of the present invention.

Fig. 28 is another diagram illustrating a locus of an immersion area in the stage structure according to the eighth embodiment.

Fig. 29 is a flowchart of a process of manufacturing a device (semiconductor chips such as IC and LSI, LCD, CCD, etc.).

Fig. 30 is a detailed flowchart of wafer process performed in step 4 in Fig. 29.

### DESCRIPTION OF THE EMBODIMENTS

Embodiments of the present invention will be described below with reference to the accompanying drawings.

### First Embodiment

An exposure apparatus according to the first embodiment will now be described with reference to the accompanying drawings. Components denoted by reference numerals with alphabetic suffixes are discussed in general when they are denoted only by the reference numerals without the alphabetic suffix.

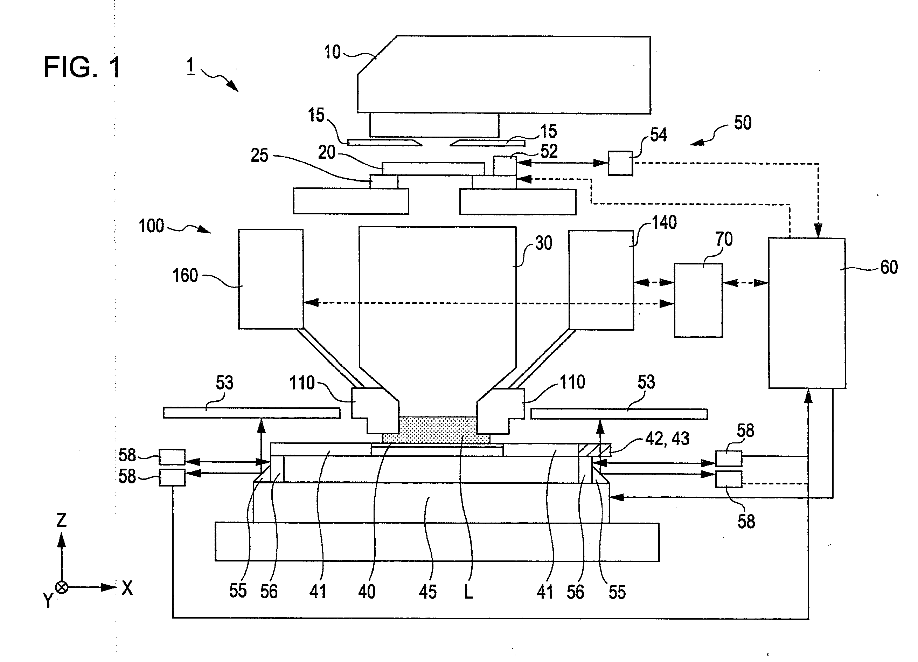

Fig. 1 is a schematic sectional view illustrating an immersion exposure apparatus 1 according to the first embodiment. The immersion exposure apparatus 1 includes a projection optical system 30 including a final lens (final optical element) having a bottom surface facing the substrate 40. The immersion exposure apparatus 1 is an immersion projection exposure apparatus which projects (transfers) a circuit pattern from a reticle 20 onto the substrate 40 through liquid L supplied between the bottom surface of the final lens and the substrate 40. Either of the step-and-repeat method and the step-and-scan method can be used as the exposure method.

Referring to Fig. 1, the immersion exposure apparatus 1 includes an illumination device 10, a masking blade 15, a reticle stage 25 on which the reticle 20 is mounted, and the projection optical system 30. The immersion exposure apparatus 1 also includes the substrate 40, an auxiliary member (hereinafter called a flush plate) 41 having a surface on the same horizontal plane as the substrate 40, and a wafer stage 45 on which the substrate 40 and the flush plate 41 are disposed. In addition, the immersion exposure apparatus 1 also includes a measurement unit 50 (52, 53, 54, 55, 56, and 58) for measuring the position of the stage 25, a stage control unit 60, an immersion control unit 70, a liquid supply-recovery device 100 (110, 140, and 160). Although the flush plate 41 is formed separately from the wafer stage 45 in Fig. 1, they may also have an integral structure according to the present invention.

The stage control unit 60 drives the reticle stage 25 and the wafer stage 45 on the basis of outputs from the measurement unit 50 including interferometers (54 and 58) and reflective mirrors (52, 53, and 56). The immersion control unit 70 receives information including the current position, velocity, acceleration, target position, moving direction, etc., of the wafer stage 45 from the stage control unit 60 and controls the immersion exposure operation on the basis of the thus-received information. For example, the immersion control unit 70 issues control commands for switching between supply and recovery of the liquid L, stopping the operation of supplying or recovering the liquid L, controlling the amount of liquid L to be supplied or recovered, etc., to a liquid supply device 140 or a liquid recovery device 160 included in the liquid supply-recovery device 100. Liquid supply means such as immersion nozzles 110 are used for simultaneously performing supply and recovery of the liquid L. Thus, a liquid film is retained on the bottom surface of the final lens (an area in which the liquid film is retained is hereinafter called an "immersion area").

The overall structure of the immersion exposure apparatus has been described above. Now, to clarify the characteristics of the present invention, an example of a conventional exposure system will be described first, and then an exposure system according to the present invention will be described.

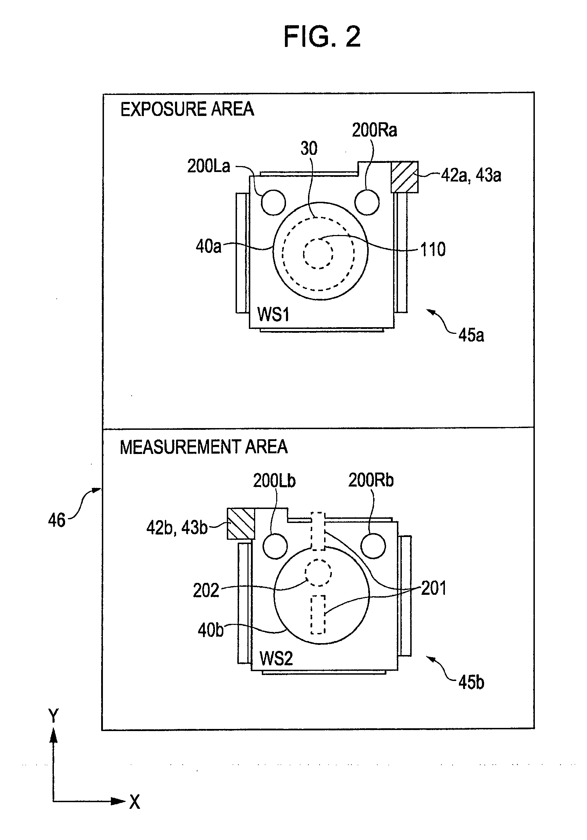

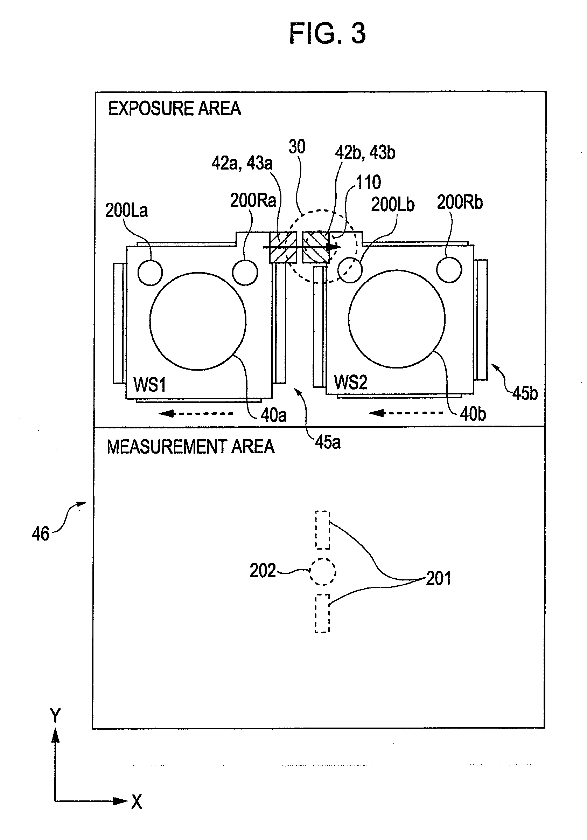

First, referring to Figs. 2 and 3, movements of wafer stages 45 in a conventional structure in an operation of switching the wafer stages 45 under a final lens of a projection optical system 30 will be described. Figs. 2 and 3 are diagrams illustrating a stage operation performed in an exposure apparatus which includes two wafer stages (WS1 and WS2) and which can perform wafer processes in a measurement area and an exposure area in parallel. In this conventional example, the first stage WS1 has a projection (hatched area) in an upper right area 42a in the figure, and the second stage WS2 has a projection (hatched area) in an upper left area 42b in the figure. Each of these projections is a part of the flush plate, and defines an area through which an immersion area passes when the immersion area is delivered to a member outside the stage. A portion used for delivering the immersion area L to the member outside the stage is hereinafter called a delivery portion 43 and a portion used for receiving the immersion area L from the member outside the stage is hereinafter called a receiving portion 42. In the structures shown in Figs. 2 to 5, the receiving portion 42 serves both the function as the receiving portion 42 and the function as the delivery portion 43.

In the measurement area, the positional relationship between the wafer 40b and the wafer stage 45b is measured with an alignment scope 202. In addition, measurement of the surface shape of the wafer 40b and focus measurement along an optical axis direction are performed using a focus scope 201. In the exposure area, the positions of the wafer 40a and the reticle 20 are measured, and the reticle pattern is projected onto the wafer 40a shot by shot.

In Fig. 2, the first stage 45a (WS1) performs an operation of positioning the wafer 40a in the exposure area and the stage 45b (WS2) performs an operation of positioning the wafer 40b in the measurement area at the same time. Then, when the wafer processes are finished in both the exposure area and the measurement area, the first stage WS1 and the second stage WS2 are moved to positions where they become adjacent to each other in the X-axis direction, as shown in Fig. 3. Then, the first stage WS1 and the second stage WS2 are synchronously moved in the -X direction while a small gap of about 0.1 mm to 1 mm is maintained therebetween (see the dotted arrows), so that the immersion area is moved from the first stage WS1 to the second stage WS2. Areas surrounding the adjacent portions 42a and 42b of the first stage WS1 and the second stage WS2, respectively, are subjected to liquid repellent finishing, and therefore the liquid cannot easily enter the gap between the stages WS1 and WS2. Thus, the stage to be used in the exposure area can be switched while the liquid is continuously retained below the final lens.

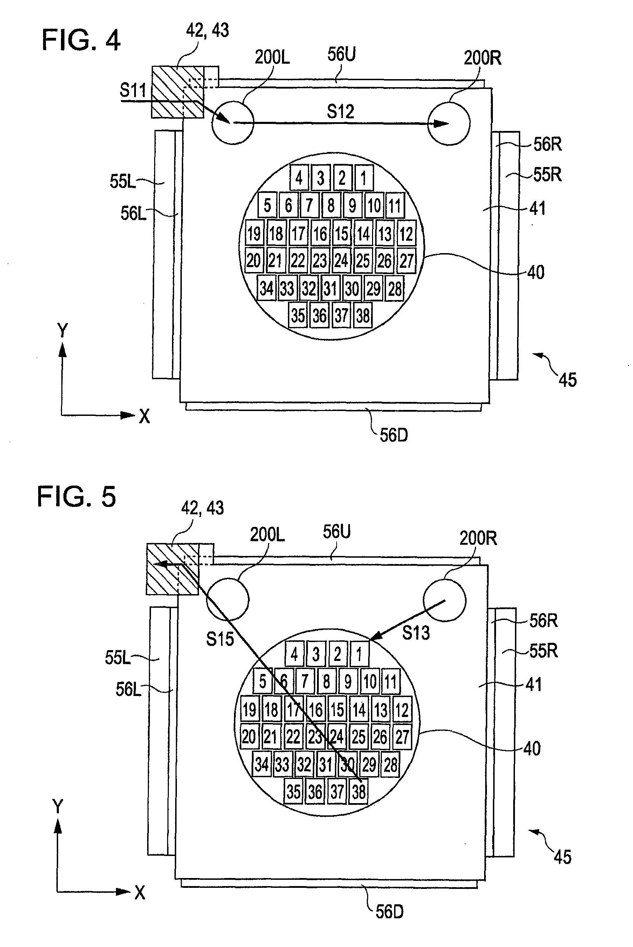

The movements of the stages will be described in more detail with reference to Figs. 4 and 5. Fig. 4 shows the moving locus along which a central region of the immersion area (i.e., a region around an optical axis of the final optical element) is moved after the immersion area is moved from the first stage WS1 to the second stage WS2. First, after the immersion area is moved to the second stage WS2, the immersion area moves to a first reference mark 200L (S11). Then, a measurement process is performed. Next, the immersion area moves to a second reference mark 200R (S12), and another measurement process is performed. By performing these measurement processes, the relative position between the reticle 20 and the second stage WS2 is calculated and a positioning reference is determined.

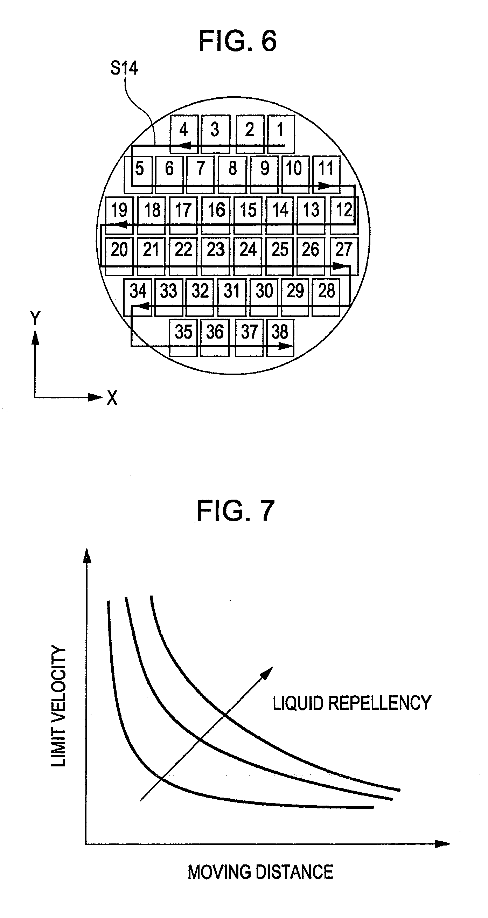

After the measurement process at the second reference mark 200R, the immersion area moves to a first shot area (S13), and a scanning exposure operation in the Y-axis direction is started (S14 in Fig. 6). In Figs. 4 to 6, an example of an array of exposure shot areas is shown on the wafer 40. The numbers in the exposure shot areas indicate the order of exposure. For explanation, in the array of the exposure shot areas, the direction of scanning exposure is defined as a column direction and a direction perpendicular thereto is defined as a row direction. In this example, in order to increase the throughput, an area in the end row and end column near the second reference mark is selected as the first shot area, as shown in Fig. 6. For example, in Fig. 5, a shot area (shot number 1) at the rightmost column in the top row (shot numbers 1 to 4), which is closest to the second reference mark 200R, is set as the first shot area. Fig. 6 shows arrows to facilitate understanding of the order of exposure. Note, however, that the arrows do not indicate the movement of the stage during exposure.

After the exposure operation, the liquid is moved to the delivery portion 42b (along path S15) to prepare for an operation of switching the stage to be used in the exposure operation. Then, the two stages are synchronously moved again while they are positioned adjacent to each other, as shown in Fig. 3. However, when the immersion area is moved from the second stage WS2 to the first stage WS1, the two stages are moved in the +X direction, opposite to the direction shown by the dotted arrows in Fig. 3. Thus, the stage-switching operation is performed.

In the structure where the present invention is not applied, the stages are moved in the above-described manner. Problems of the above-described stage movements will now be described.

As described above, in order to retain the liquid film without causing the liquid to spill or remain, for example, on the substrate when the stage is moved, the stage must be moved at a velocity equal to or lower than the limit velocity determined by the liquid repellency of the moving surface and the moving distance. Fig. 7 shows the basic relationship between the liquid repellency, the moving distance, and the limit velocity. If the moving distance is that required in the exposure operation (e.g. between adjacent die), the stage can be moved at a high velocity even when the liquid repellency is that of a wafer surface. However, if the stage is moved by a longer distance than that required in the exposure operation, as in the above-described movement (S15) performed immediately after the exposure operation, the limit velocity is considerably reduced compared to that in the exposure operation. Therefore, a long moving time is required.
Such a long moving time reduces the overall productivity of the apparatus. Therefore, it is desirable to avoid such a long-distance movement in the wafer processes.

In addition, when the immersion area is moved along the substrate 40 as in the above-described movement (S15 in Fig. 5) performed immediately after the exposure operation, there is a relatively higher possibility that exposure defects will occur. More specifically, the resist applied to the wafer 40 can easily react with the liquid, such as pure water, and may cause failure in the exposure operation or the development operation. Therefore, the contact area and/or contact time between the resist on the wafer 40 and the liquid is required to be as small as possible in the exposure operation.

Embodiments of the present invention aim to address at least one of the above-described two problems. The first embodiment of the present invention will be described below with reference to Figs. 7 to 12. To avoid redundant explanations, structures similar to those in the above-described example in which the present invention is not applied (Figs. 2 to 6) will not be explained again below.

The present embodiment provides a delivery portion and a receiving portion on each stage for delivering and receiving the liquid. In the structure shown in Figs. 2 to 5, each stage is provided with a single receiving portion 42 that serves both the function as the receiving portion and the function as the delivery portion 43. Therefore, the above-described long-distance movement (S15) along the wafer is performed immediately after the exposure operation. In comparison, according to the present embodiment, a delivery portion 43 is independently provided near the last exposure shot area. In a normal exposure operation, the immersion area is moved to the reference mark (first reference mark) that is measured immediately after the immersion area is received. Therefore, the receiving portion 42 is disposed near the reference mark 200 measured immediately after the reception of the immersion area L. In other words, the receiving portion 42 is disposed on the same side as the reference mark 200 which is measured immediately after the reception of the immersion area with respect to a straight line that passes through the center of the wafer 40 and extends perpendicular to the scanning direction (Y-axis direction). In addition, the receiving portion 42 is also disposed on the same side as the reference mark 200 which is measured immediately after the reception of the immersion area with respect to a straight line that passes through the center of the wafer 40 and extends in a direction parallel to the scanning direction (Y-axis direction). In addition, in order to reduce the distance by which the immersion area is moved immediately after the exposure operation, the delivery portion 43 is provided at a position near the last exposure shot area. The shot layout and the order of exposure are determined taking various conditions into account, and are not fixed. In the present embodiment, the stage structure is determined on the assumption that the most common shot layout and order of exposure are used and the last shot area is on the row that is farthest from the reference marks. More specifically, when the most common order of exposure is used, the last exposure shot area is probably on the side opposite to the reference mark (second reference mark) which is measured immediately before the exposure operation with respect to the straight line that passes through the center of the wafer and extends perpendicular to the scanning direction (Y-axis direction). Therefore, the delivery portion is provided at a position near the thus-assumed last exposure shot area.

The operation procedure for switching the stage to be used in the exposure operation below the projection lens in the above-described structure will now be described.

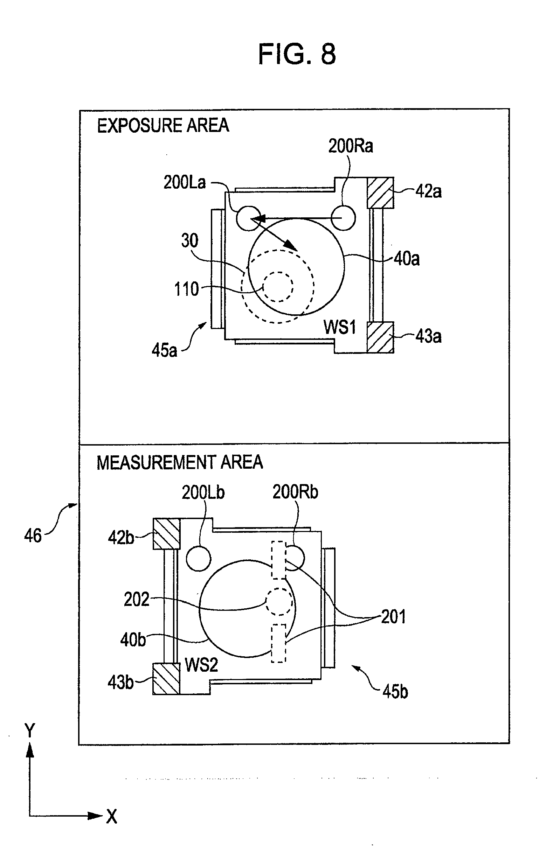

Fig. 8 shows a locus of the immersion area moved as the stage is moved immediately after the stage positioned under the projection lens is switched from the stage WS2 to the stage WS1. More specifically, the immersion area moves from the first receiving portion 42a to the first reference mark 200Ra, where the first reference mark 200Ra is measured, and is then moved to the second reference mark 200La, where the second reference mark 200La is measured. Accordingly, the relative position between the reticle 20 and the wafer stage 45 is calculated. Then, the immersion area is moved to the first shot area on the wafer and the scanning exposure operation is performed in the Y-axis direction. More specifically, exposure is successively carried out at each of the exposure shot areas.

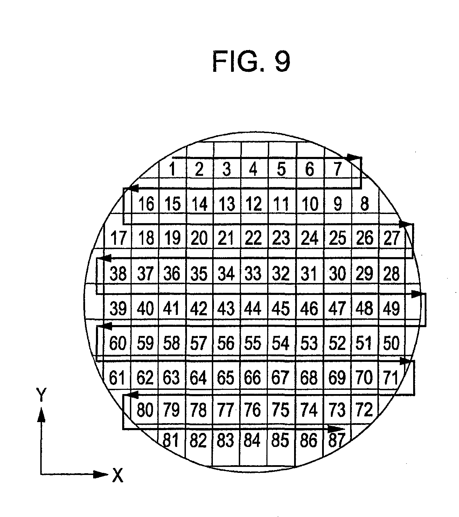

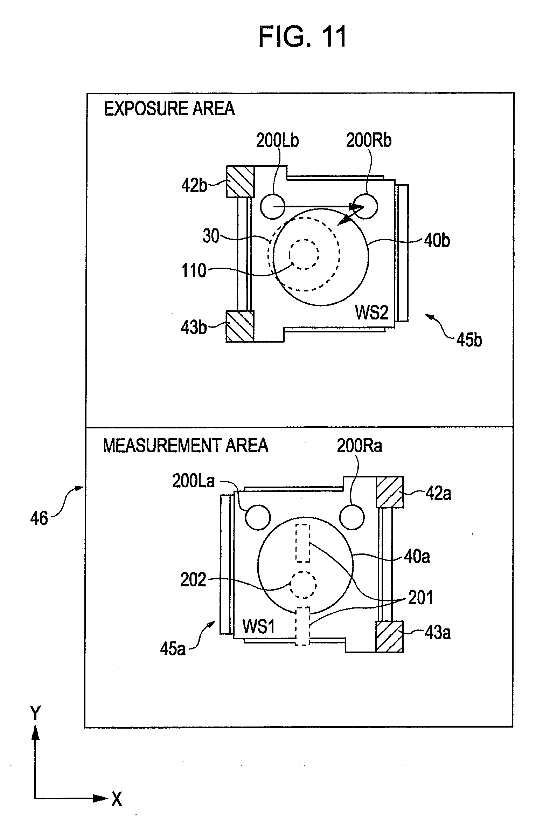

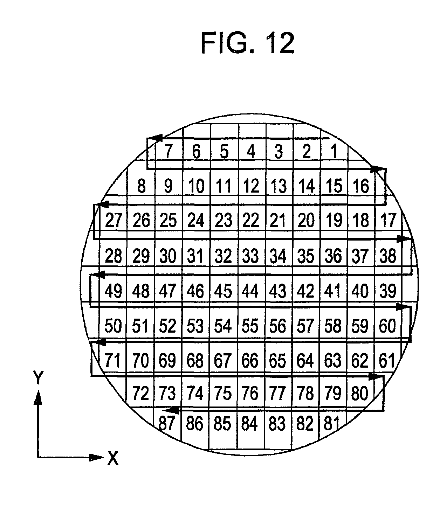

To increase the throughput, the first shot area is selected so as to make the total moving distance in the exposure operation as small as possible. More specifically, the first shot area is disposed on the same side as the reference mark measured immediately before the exposure operation with respect to the straight line that passes through the center of the wafer and extends perpendicular to the scanning direction. In more detail, when the direction of scanning exposure is defined as a column direction, a shot area on the end row and end column near the reference mark 200 measured last is selected as the first shot area. For example, in the first stage WS1, the reference mark 200La which is measured immediately before the exposure operation (i.e., which is measured last) is at the upper left in Fig. 8. Therefore, as shown in Fig. 9, the shot area at the upper left corner is selected as the first shot area. In addition, in the second stage WS2, the reference mark 200Rb which is measured last is at the upper right in Fig. 11. Therefore, as shown in Fig. 12, the shot area at the upper right corner is selected as the first shot area.

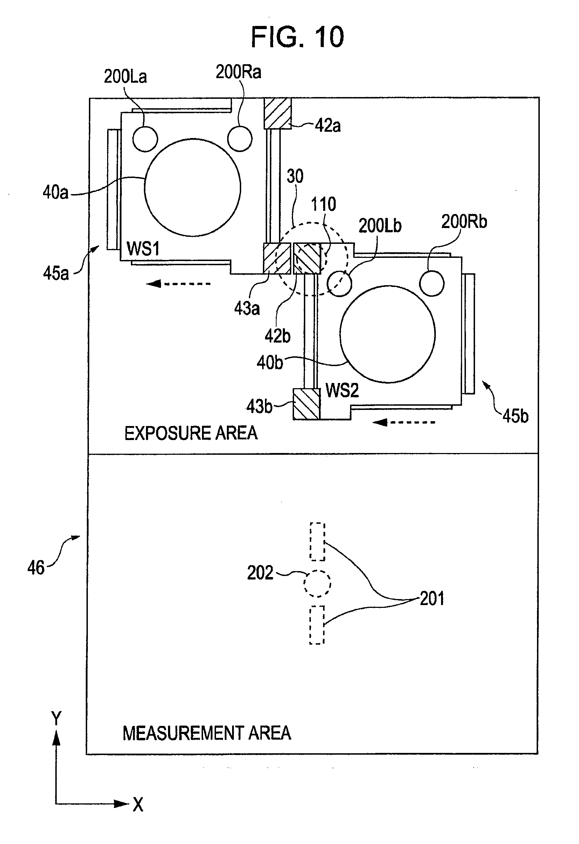

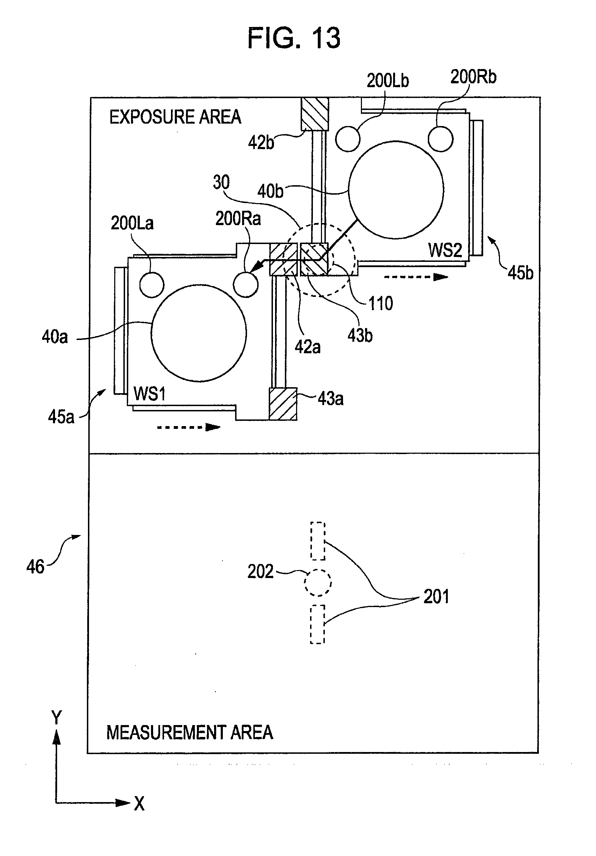

After exposure at the last shot area (87th shot area in Fig. 9) on the first stage WS1 is finished, the delivery portion 43a of the first stage WS1 and the receiving portion 42b of the second stage WS2 are positioned adjacent to each other in X-axis direction, as shown in Fig. 10. A small gap of 1 mm or less may be provided between the adjacent portions that are subjected to liquid repellent finishing so that the liquid can be prevented from spilling from the stages when they are positioned adjacent to each other. Alternatively, an elastic member, such as rubber, may be brought into physical contact between the adjacent portions. Then, the two stages (WS1 and WS2) are synchronously moved leftward in the figure (-X direction) as shown by the dotted arrows, so that the immersion area is moved from the first stage WS1 (45a) to the second stage WS2 (45b). Then, the first stage WS1 is moved to the measurement area, and the immersion area on the second stage WS2 is moved to the first reference mark 200Lb. Then, as shown in Fig. 11, the immersion area on the second stage WS2 is moved to the second reference mark 200Rb, where the second reference mark 200Rb is measured, and then the exposure operation is performed in the order shown in Fig. 12. At the same time, a wafer exchanging operation and various measurements for a new wafer are performed on the first stage WS1. After exposure at the last shot area on the second stage WS2 is finished, the delivery portion 43b of the second stage WS2 and the receiving portion 42a of the first stage WS1 are positioned adjacent to each other in the X-axis direction, as shown in Fig. 13. Then, the two stages (WS1 and WS2) are synchronously moved rightward in the figure (+X direction) as shown by the dotted arrows, so that the immersion area is moved from the second stage WS2 to the first stage WS1.

An example of the operation procedure for successively processing the wafers on two stages by switching the stage used for the immersion exposure operation has been described. Now, advantages obtained by the above-described structure will be described.

Since the delivery portion 43 is disposed near the last exposure shot area, the moving distance by which the immersion area is moved immediately after the exposure operation can be reduced. In addition, the immersion area is moved along the flush plate 41 which is adapted to have a higher liquid repellency than that of the wafer 40. Therefore, the immersion area can be moved at a relatively high velocity, as is clear from the relationship shown in Fig. 7. Therefore, the immersion area can be moved by a shorter distance at a higher velocity after the exposure operation. As a result, the moving time can be reduced compared to that of the movement denoted by S15 in Fig. 5, and the throughput of the exposure apparatus can be increased.

In addition, the contact area in which the immersion area comes into contact with the surface of the wafer 40 when the immersion area is moved immediately after the exposure operation can be greatly reduced. In addition, the wafer surface is relatively uniformly in contact with the liquid in terms of time. Therefore, exposure defects caused by reaction between the resist and the liquid can be suppressed, and the reliability of the immersion exposure apparatus can be increased.

In the present embodiment, the two reference marks 200L and 200R are separated form each other in a direction (X-axis direction) that is perpendicular to the scanning direction (Y-axis direction). This allows higher accuracy measurement of an inclination around the scanning direction (Y-axis direction). More specifically, a positioning reference in the Z direction can be obtained using a single reference mark 200, and a positioning reference for inclination around the Y axis can be accurately calculated on the basis of the information obtained by measuring a plurality of reference marks 200 separated from each other in the X-axis direction. The measurement accuracy is increased in proportion to the distance between the reference marks 200L and 200R. Since high accuracy measurement and positioning can be achieved for the inclination around the scanning direction (Y-axis direction), focus state in the exposure slit can be made uniform in the longitudinal direction in a scanning exposure operation. In other words, the exposure accuracy of the exposure apparatus can be increased.

### Second Embodiment

In the first embodiment, as shown in Figs. 8, 10, and 11, each stage has the receiving portion 42 and the delivery portion 43 on projections provided at respective corners of the stage. However, the projections may also be omitted. These projections are provided to prevent interference with the interference mirrors (55 and 56) used for position measurement and optical axes of the interference mirrors. Therefore, depending on the structure of the interferometers, the immersion area can be delivered and received without providing the projections. According to the present embodiment, the stages are free from the projections at the corners. Structures other than the presence/absence of the projections are similar to those in the first embodiment, and detailed explanations thereof are thus omitted.

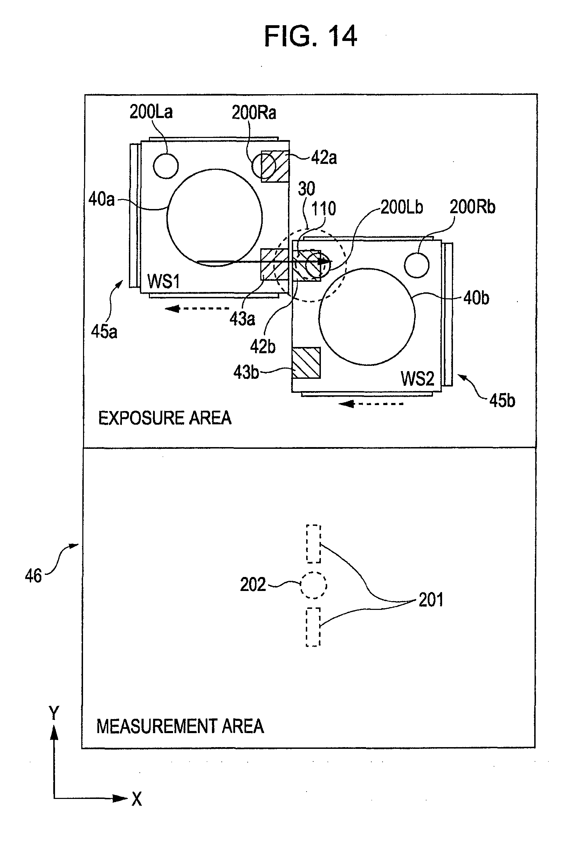

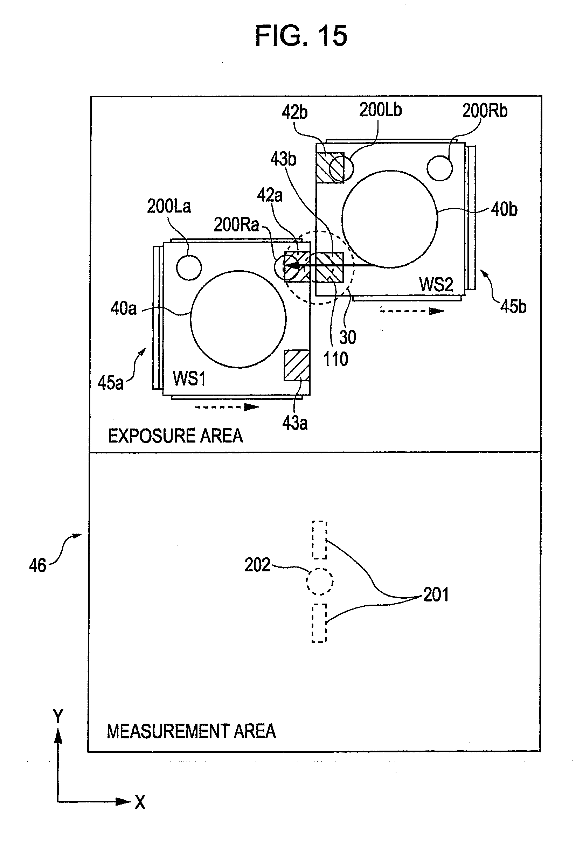

Figs. 14 and 15 are diagrams illustrating the structure of the present embodiment corresponding to Figs. 10 and 13, respectively, of the first embodiment.
Referring to Fig. 14, a receiving portion 42 and a delivery portion 43 are provided on each of the right side of the first stage WS1 and on the left side of the second stage WS2. Fig. 14 shows the state in which the immersion area is moved from the first stage WS1 to the second stage WS2, and Fig. 15 shows the state in which the immersion area is moved from the second stage WS2 to the first stage WS1.
The manner in which the immersion area is moved as the stages are moved is similar to that in the first embodiment.

In the structure of the present embodiment, freedom of arrangement of the receiving portion 42 and the delivery portion 43 is increased. Therefore, the receiving portion 42 and the delivery portion 43 can be disposed on a straight line connecting the expected last exposure shot area and the reference marks 200. In such a case, the distance by which the immersion area is moved after the exposure can be reduced compared to that in the first embodiment, and the throughput can be further increased.
In addition, similar to the first embodiment, the immersion area is not moved along the wafer 40 after the exposure operation. Therefore, exposure defects caused by reaction between the resist and the liquid can be suppressed.

### Third Embodiment

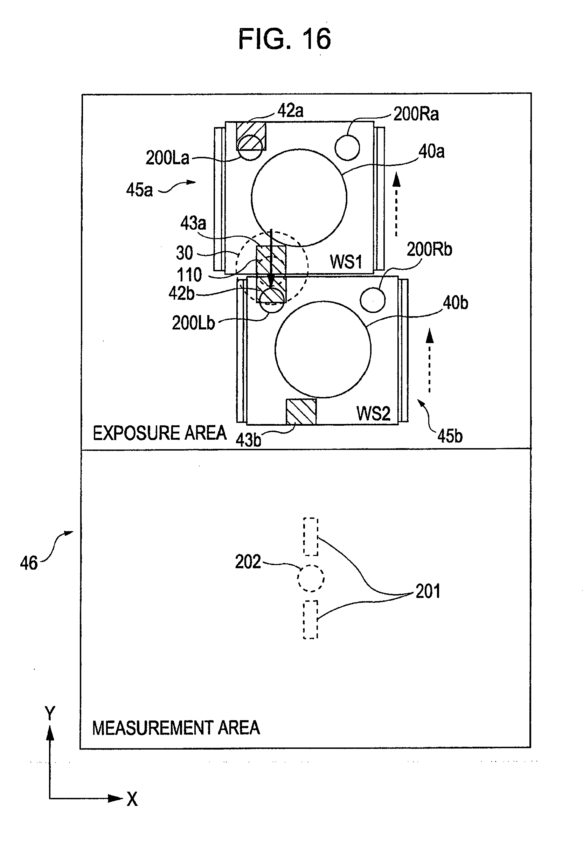

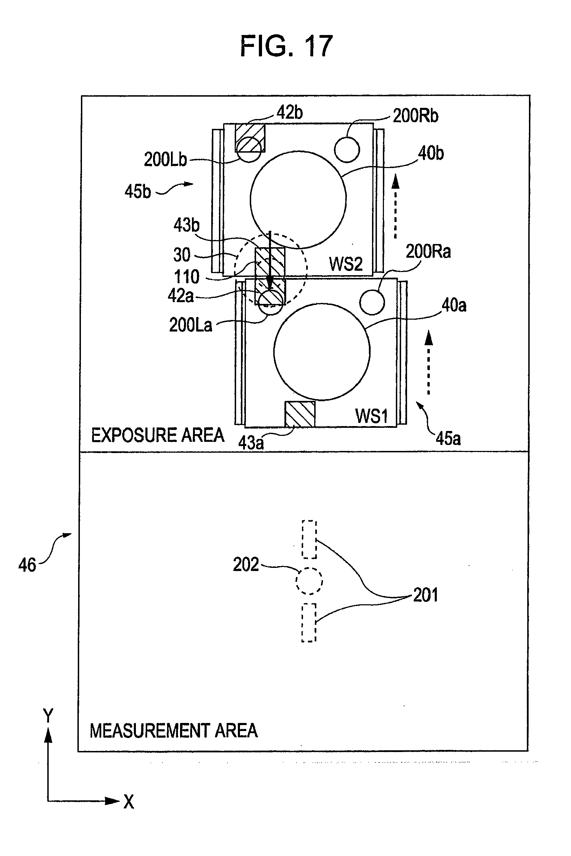

In the first and second embodiments, the two stages are synchronously moved in the X-axis direction to deliver and receive the immersion area. However, the structure of the present invention can also be applied to a system in which the immersion area is delivered and received by a synchronous movement in the Y-axis direction. Figs. 16 and 17 are diagrams illustrating the present embodiment in which each stage has the receiving portion 42 and the delivery portion 43a on the sides facing each other in the Y-axis direction. Fig. 16 shows the state in which the immersion area is moved from the first stage WS1 to the second stage WS2. The two stages are positioned adjacent to each other in the Y-axis direction, and are synchronously moved in the +Y direction so as to move the immersion area L. In each stage 45, to reduce the moving time before and after the exposure operation, the receiving portion 42 is disposed near the reference marks 200 and the delivery portion 43 is disposed near the last exposure shot area. The receiving portion 42 is disposed on a side of each stage 45 in the Y-axis direction at a position near the reference marks 200. More specifically, the receiving portion 42 is disposed near the reference mark 200 which is measured first after the immersion area is received. Accordingly, the moving time of the stage can be further reduced. In addition, the delivery portion 43 is disposed on the other side of the stage 45 in the Y-axis direction, that is, on the side far from the reference marks 200 at a position near the expected last shot area. Therefore, the moving time of each stage 45 can be further reduced and the throughput can be increased. In addition, similar to the other embodiments, the immersion area is not moved along the wafer 40 after the exposure operation. Therefore, exposure defects caused by reaction between the resist and the liquid can be suppressed. In addition, since the reference marks 200 are separated from each other in a direction perpendicular to the scanning direction, the positioning accuracy for the inclination around the scanning direction is increased. Therefore, the exposure accuracy is increased.

### Fourth Embodiment

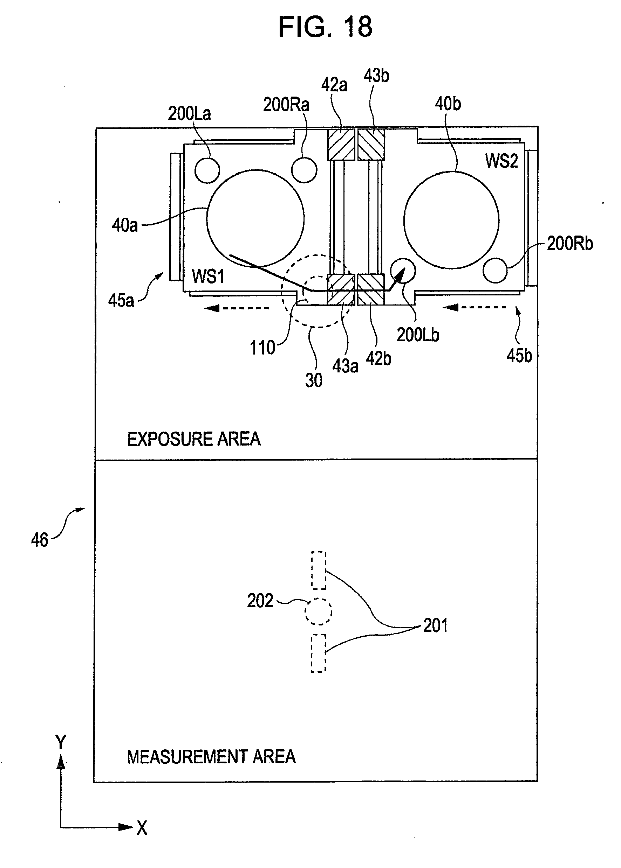

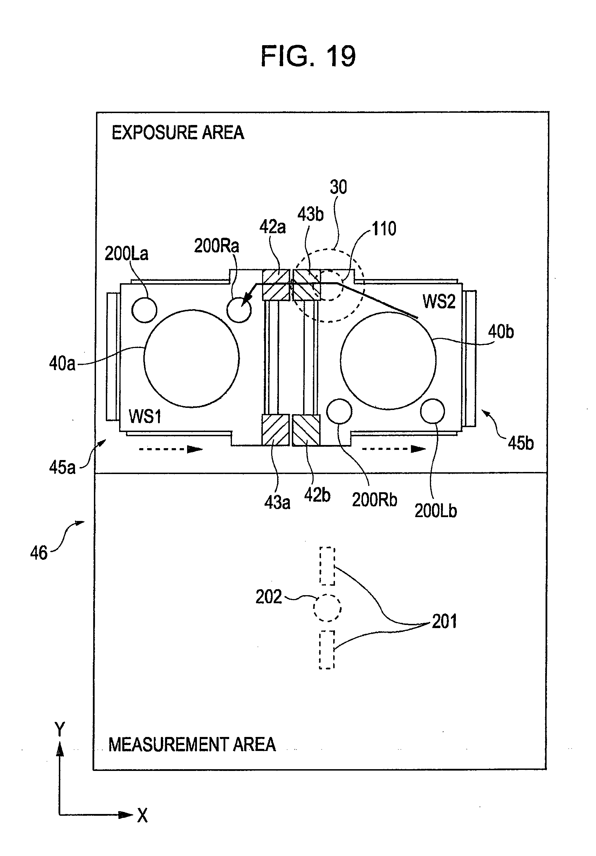

A fourth embodiment will be described below with reference to Figs. 18 and 19. The fourth embodiment is characterized in that the arrangement positions of the reference marks 200 are changed from those in the first embodiment. Accordingly, the arrangement of the two stages 45 in the process of moving the immersion area between the stages is also changed. The present embodiment will be described in detail below.

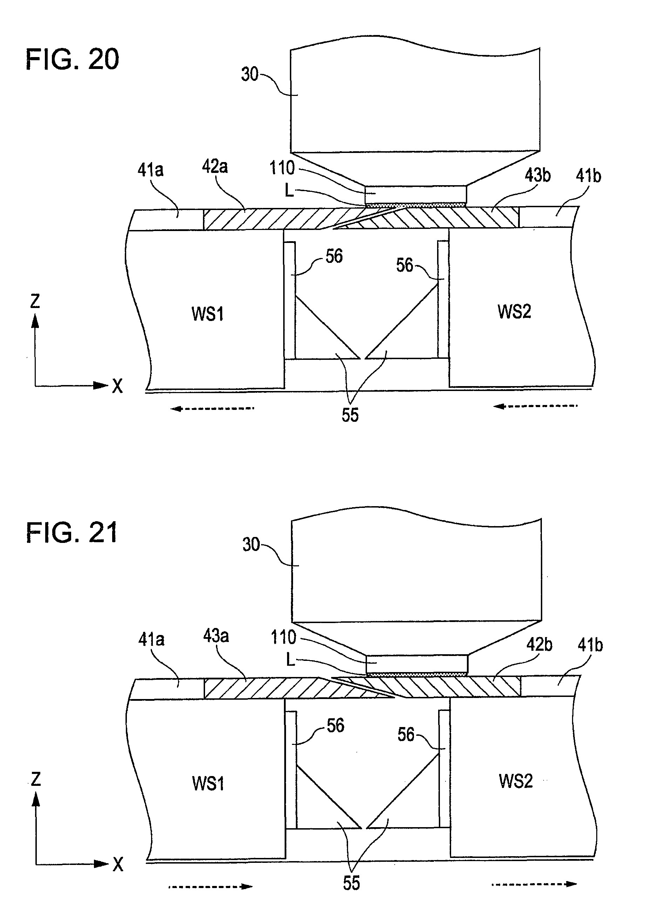

Fig. 18 corresponds to Fig. 10 according to the first embodiment, and shows the state in which the immersion area is moved from the first stage WS1 to the second stage WS2. The difference between Fig. 18 and Fig. 10 will be described below. That is, in Fig. 18, the reference marks 200 of the second stage WS2 are positioned on the side opposite to the reference marks 200 of the first stage WS1 with respect to a line extending through the center of the wafer in a direction (X-axis direction) perpendicular to the scanning direction. More specifically, the reference marks 200Ra and 200La on the first stage WS1 are positioned on the +Y side of the stage WS1, whereas the reference marks 200Rb and 200Lb of the second stage WS2 are positioned on the -Y side of the stage WS2. In the first stage WS1, the reference mark which is measured first after the immersion area is received is the reference mark 200Ra on the +X side. In the second stage WS2, the reference mark which is measured first after the immersion area is received is the reference mark 200Lb on the -X side. Fig. 19 corresponds to Fig. 13 according to the first embodiment, and illustrates the state in which the immersion area is moved from the second stage WS2 to the first stage WS1. Since the reference marks 200 are arranged as described above, when the immersion area is moved, it is not necessary to place the first stage WS1 and the second stage WS2 at positions adjacent to each other but shifted from each other in the Y-axis direction as shown in Fig. 10. Therefore, when the immersion area is moved between the stages 45, it is not necessary to change the positional relationship between the stages 45 depending on the moving direction of the immersion area as shown Figs. 10 and 11. Therefore, the movement of the stages 45 is simplified and the stages 45 can be easily controlled. In addition, when the immersion area is moved between the stages 45, the same pair of portions (42a and 43b, 43a and 42b) are always positioned adjacent to each other. Therefore, the following structure can be applied. That is, although the stages 45 are moved while being positioned adjacent to each other to continuously retain the immersion area on the stages 45, there is a risk that the liquid will spill from the stages 45 when a small gap is provided therebetween. Therefore, surfaces around the adjacent portions (42 and 43) are subjected to liquid repellent finishing, so that the liquid can be prevented from entering the gap due to capillarity action. In addition, according to the present embodiment, as shown in Figs. 20 and 21, the adjacent edges of portions 42 and 43 can be tapered and superimposed in accordance with the moving direction of the immersion area (moving direction of the stages) so that the liquid can be more reliably prevented from spilling out of the stages 45.
Fig. 20 is a sectional view of the stages in the state in which the immersion area is moved from the first stage WS1 to the second stage WS2. Edges of the adjacent portions (42 and 43) are tapered in accordance with the moving direction of the immersion area relative to the stages. In this case, the immersion area L cannot easily enter the gap between the stages. Similarly, Fig. 21 is a sectional view of the stages in the state in which the immersion area is moved from the second stage WS2 to the first stage WS1.
The direction of inclination at the edges of the adjacent portions (42 and 43) is opposite to that shown in Fig. 20 because the moving direction of the immersion area (moving direction of the stages) is opposite to that in Fig. 20. This structure can be applied because when the immersion area is moved between the stages 45, each pair of the adjacent portions (the receiving portion 42 and the delivery portion 43) is always in the same state irrespective of the moving direction of the immersion area. In comparison, in the first embodiment, the adjacent portions (the receiving portion 42 and the delivery portion 43) of the stages cannot be inclined because the inclination directions thereof do not always match. Also in the present embodiment, similar to the other embodiments, the low-velocity, long-distance movement can be eliminated and the liquid L is suppressed from coming into contact with the wafer 40 after the exposure operation. Therefore, the throughput can be increased and the occurrence of exposure defects can be reduced. In addition, since the reference marks 200 are separated from each other in a direction perpendicular to the scanning direction, the positioning accuracy for the inclination around the scanning direction is increased. Therefore, the exposure accuracy is increased.

### Fifth Embodiment

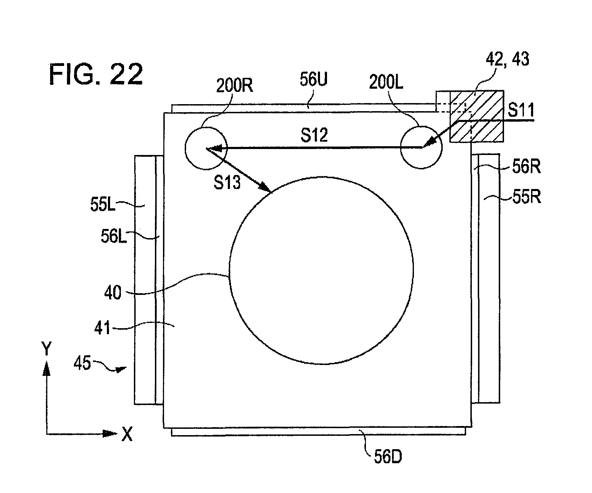

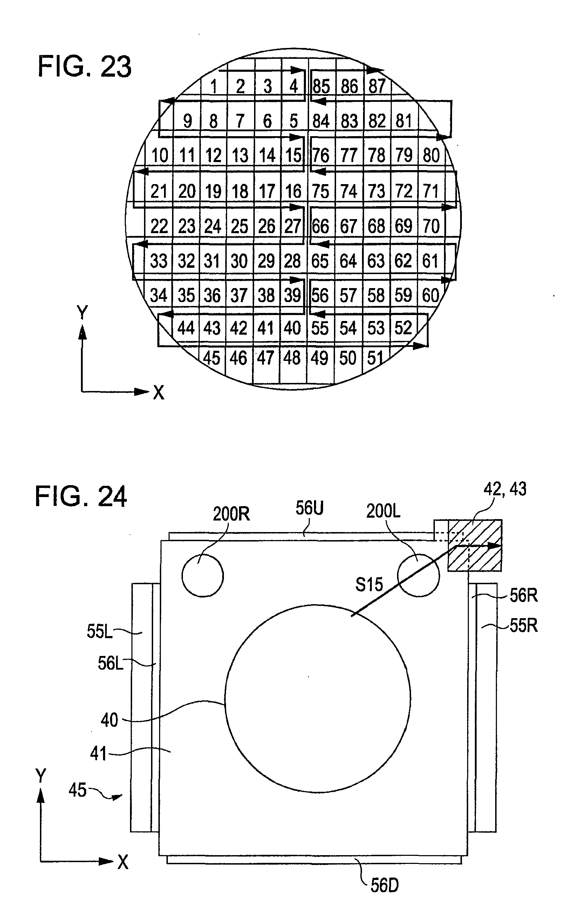

Figs. 22 to 24 illustrate the structure of a fifth embodiment in which the moving times before and after the exposure operation are reduced by changing the order of exposure. The structure of the stages 45 according to the present embodiment is similar to that of the conventional system shown in Fig. 2. However, the order of exposure is different from that in the conventional system. This will be described in more detail. First, the immersion area received by the receiving portion 42 is moved to the first reference mark 200L, where the first reference mark 200L is measured. Then, the immersion area is moved to the second reference mark, where the second reference mark is measured. Then, the exposure operation is started. Referring to Fig. 23, first, shot areas in about one-half of the wafer on the -X side thereof are subjected to exposure. Then, the exposure area is moved along the bottom row into the +X side of the wafer, and returns to the top row. The essence of this order of exposure is that the first shot area and the last shot area are on the same side with respect to a line that passes through the center of the wafer 40 and extends perpendicular to the scanning direction. Therefore, the present invention is not limited to the order of exposure shown in Fig. 23. More specifically, in the conventional order of exposure, the first shot area and the last shot area are on the rows at the opposite ends when the scanning direction is defined as the column direction, and are never positioned on the same row. Therefore, the distance by which the immersion area is moved after the exposure operation is long (S15 in Fig. 5) and the throughput cannot be increased. In comparison, according to the present embodiment, the order of exposure is determined such that the first shot area and the last shot area can be placed on the same row. Therefore, the distance by which the immersion area is moved after the exposure operation can be reduced (Fig. 24) and the throughput can be increased. Also in the present embodiment, like in the other embodiments, the liquid comes into contact with the wafer a reduced amount, and so the occurrence of exposure defects can be reduced.

### Sixth Embodiment

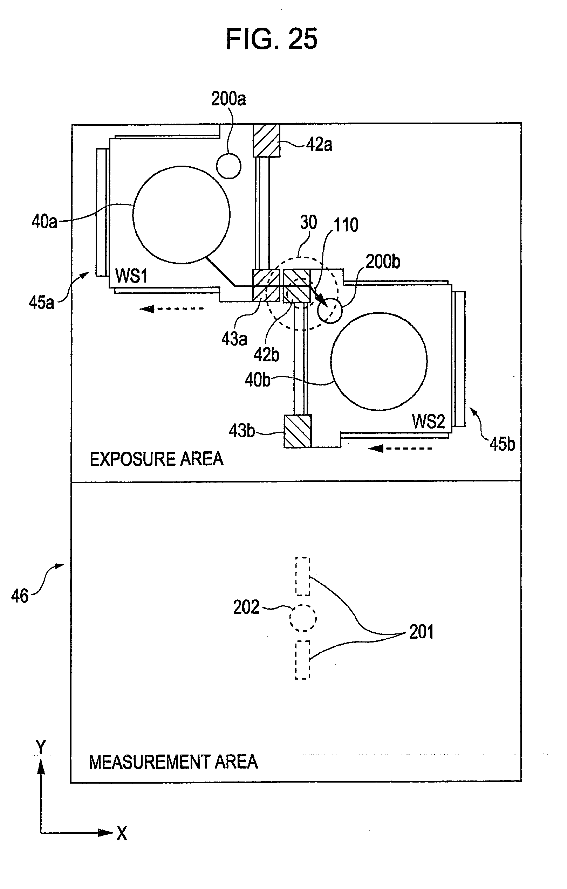

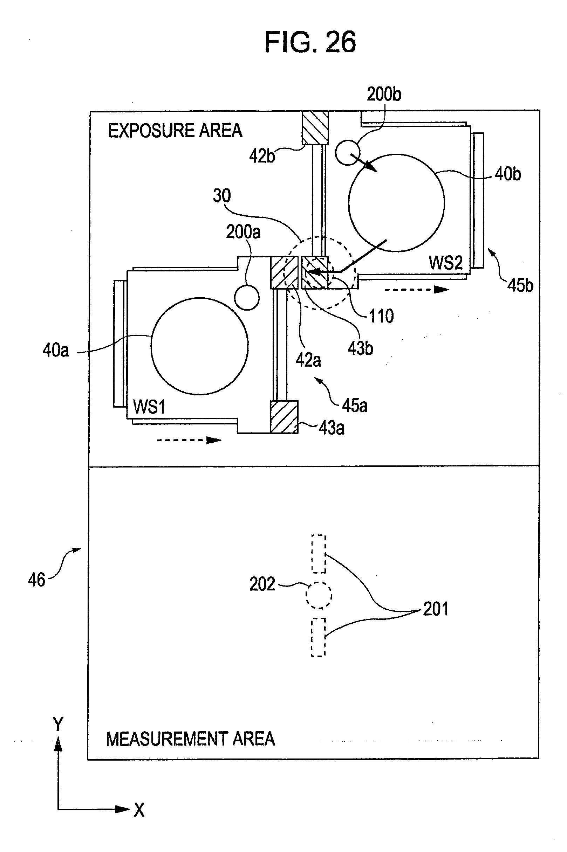

Although the examples in which two reference marks 200 are provided are explained in the above embodiments, the number of the reference marks is not limited to two in the present invention. For example, Figs. 25 and 26 show the structure of a sixth embodiment in which only one reference mark 200 is provided. In the present invention, the reference mark is defined as a member including one or more measurement marks used for measuring a positioning reference. Fig. 25 shows the state in which the immersion area L is moved from the first stage WS1 to the second stage WS2. The solid arrow shows the moving locus of the immersion area, and the dashed arrows show the moving direction of the two stages 45 in this process. The immersion area moves between the stages 45 by passing through the delivery portion 43a of the first stage WS1 and the receiving portion 42b of the second stage WS2. Then, the immersion area is moved to the reference mark 200b of the second stage WS2. Then, as shown in Fig. 26, the reference mark 200b is measured and the exposure operation is performed. After the exposure operation, the delivery portion 43b of the second stage and the receiving portion 42a of the first stage are positioned adjacent to each other, and the immersion area is moved from the second stage WS2 to the first stage WS1. Then, the reference mark on the first stage is measured and the exposure operation is performed in a similar manner, and the immersion area is moved between the stages. Thus a plurality of wafers 40 can be processed.

### Seventh Embodiment

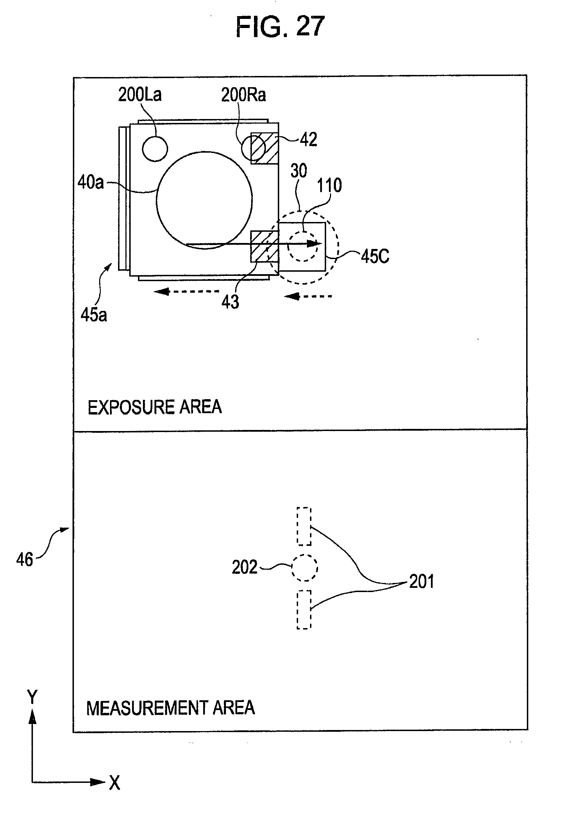

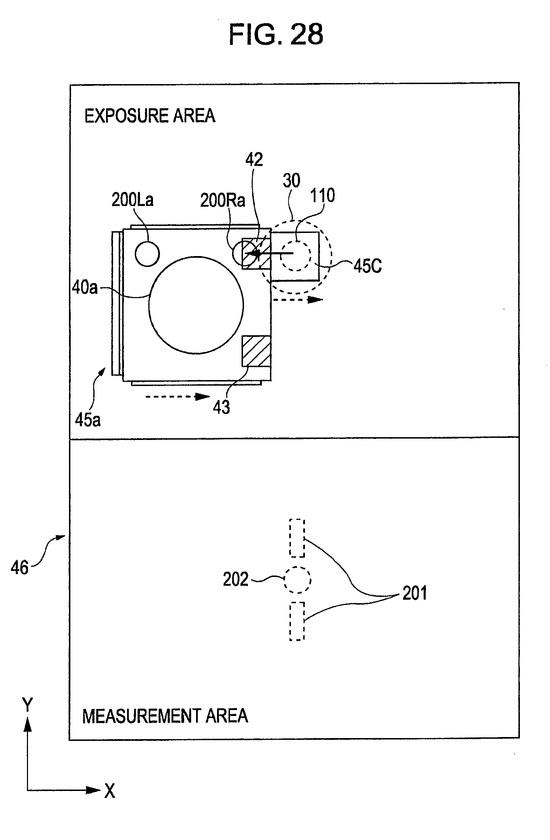

In the first to sixth embodiments, the immersion area is moved between a plurality of wafer stages (WS1, WS2) that can be used in the exposure operation. However, the present invention is characterized in the relative positions between the receiving portion and the delivery portion in at least one wafer stage that can be used in the exposure operation. Therefore, there is no limit to a member to which or from which the immersion area is moved, and the member to which or from which the immersion area is moved is, of course, not limited to a wafer stage that can be used in the exposure operation. Figs. 27 and 28 illustrate the structure of a seventh embodiment in which a member to which and from which the immersion area is moved is an immersion-area standby stage 45C. An exposure apparatus shown in Figs. 27 and 28 includes a stage 45a that can be used in the exposure operation of the substrate 40 and the immersion standby stage 45C used for temporarily holding the immersion area L when the stage 45a is moved to the measurement area. Fig. 27 shows the state in which the immersion area is moved from the wafer stage 45a to the immersion standby stage 45C. The solid arrow shows the moving locus of the immersion area, and the dashed arrows show the moving direction of the two stages in this process. Similar to the other embodiments, the two stages 45 are synchronously moved while being positioned adjacent to each other or in contact with each other. At this time, assuming that the last exposure shot area is at a commonly set position, the delivery portion 43 from which the immersion area is moved is disposed on the side opposite to the reference mark 200La, which is measured immediately before the exposure, with respect to a line that passes through the center of the wafer and extends perpendicular to the scanning direction. Then, the wafer stage 45a is moved to the measurement area and various processes are performed (not shown) while the immersion standby stage 45C is in a steady state. After the processes are finished in the measurement area, the wafer stage 45a is positioned adjacent to the immersion standby stage 45C or is brought into contact with the immersion standby stage 45C, as shown in Fig. 28, and the two stages are synchronously moved as shown by the dashed arrows, so that the immersion area is moved from the immersion standby stage 45C to the wafer stage 45a. At this time, the receiving portion 42 through which the immersion area is moved is disposed in a region near the reference mark 200Ra that is measured first after the immersion area is received. The region near the reference mark 200Ra is defined as an area on the same side as the reference mark 200Ra with respect to at least one of a line that passes through the center of the wafer 40 and extends perpendicular to the scanning direction and a line that passes through the center of the wafer 40 and extends parallel to the scanning direction.

### Eighth Embodiment

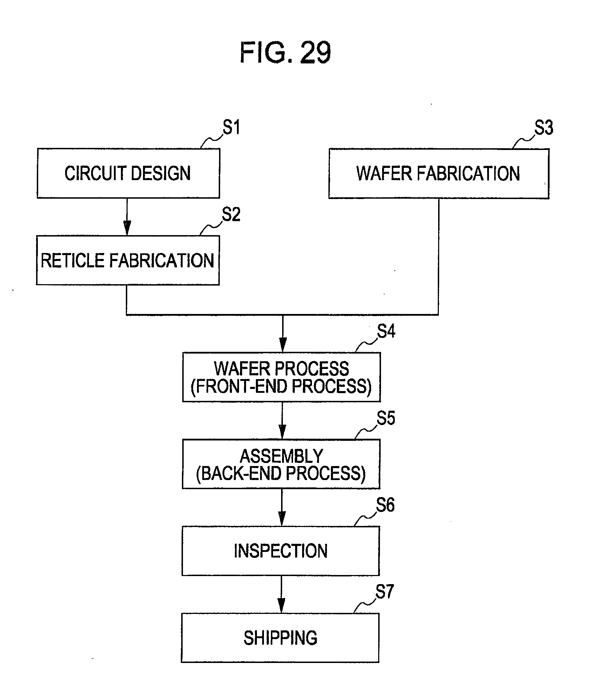

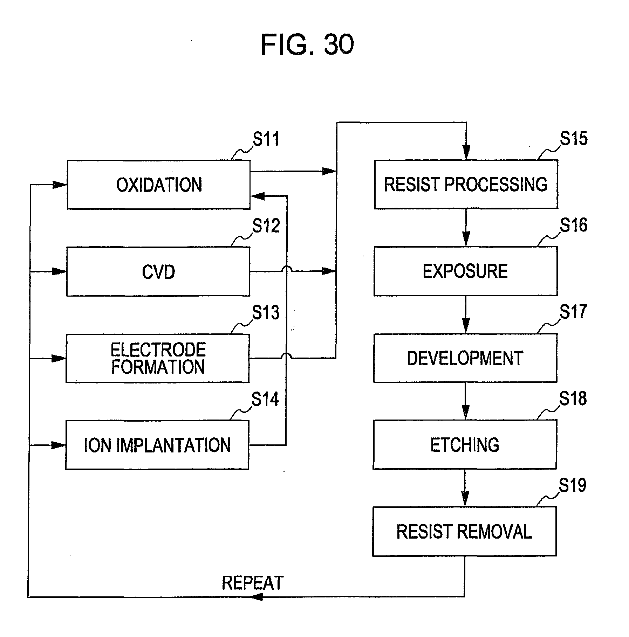

An example of a device manufacturing method using the above-described immersion exposure apparatus 1 will be described below with reference to Figs. 29 and 30. Fig. 29 is a flowchart showing processes for manufacturing devices (for example, semiconductor chips such as ICs and LSIs, LCDs, and CCDs). In this example, a manufacturing method of semiconductor chips will be described. In Step S1 (circuit design), a circuit of semiconductor chips is designed. In Step S2 (reticle fabrication), a reticle is fabricated in the designed circuit pattern. In Step S3 (wafer fabrication), a wafer is formed of a material such as silicon. In Step S4 (wafer process), called a front-end process, actual circuits are formed on the wafer by lithography with the reticle and the wafer using the exposure apparatus. In Step S5 (assembly), called a back-end process, semiconductor chips are formed from the wafer obtained in Step S4. This process includes an assembly process (dicing and bonding) and a packaging process (chip sealing). In Step S6 (inspection), the semiconductor chips obtained in Step S5 are tested for, for example, operation and durability. The semiconductor chips are thus completed through the above processes, and are then shipped (Step S7).

Fig. 30 is a detailed flowchart of the wafer process performed in Step S4 shown in Fig. 29. In Step S11 (oxidation), the surface of the wafer is oxidized. In Step S12 (CVD), an insulating film is formed on the surface of the wafer. In Step S13 (electrode formation), electrodes are formed. In Step S14 (ion implantation), ions are implanted into the wafer. In Step S15 (resist processing), a photosensitive agent is applied to the wafer. In Step S16 (exposure), the circuit pattern of the reticle is projected onto the wafer by the immersion exposure apparatus 1. In Step S17 (development), the exposed wafer is developed. In Step S18 (etching), parts other than the developed resist image are etched away. In Step S19 (resist removal), the resist, which becomes unnecessary after etching, is removed. By repeating these steps, a multi-layer circuit pattern is formed on the wafer. According to the above-described device manufacturing method, devices with quality higher than that of conventional devices can be obtained. Thus, the device manufacturing method using the immersion exposure apparatus 1 and the device obtained by the manufacturing method also constitute an aspect of the present invention.

While the present invention has been described with reference to exemplary embodiments, it is to be understood that the invention is not limited to the disclosed exemplary embodiments but to the scope of the following claims.

## Claims

1. A scanning immersion exposure apparatus (1), comprising:
a projection optical system (30);
a stage (45) configured to move with a substrate (40) mounted thereon; and
liquid supply means (110) configured to supply liquid to a local area between the projection optical system (30) and the stage (45) and recover the supplied liquid,
wherein the stage (45) includes
a delivery portion (43) configured to enable the local area in contact with the liquid from the stage (45a) to be moved to a further stage (45b), and
one or more reference marks (200) provided on the stage (45) for positioning the stage (45) with respect to a reticle (20), **characterized in that**
when in use the scanning immersion exposure apparatus is arranged such that the delivery portion (43a) and one of said one or more reference marks (200Ra) measured immediately before exposure are disposed on opposite sides of a first line that passes through the center of the substrate (40) and extends perpendicular to a scanning direction.

2. The exposure apparatus according to claim 1, wherein the stage (45) further includes a receiving portion (42) for receiving said area from said another member, and
wherein the receiving portion (42) is disposed on the same side as one of said one or more reference marks (200) that is measured immediately after reception of said area with respect to the first line.

3. The exposure apparatus according to claim 2, wherein the receiving portion (42) is disposed on the same side as the one of said one or more reference marks (200) that is measured immediately after reception of said area with respect to a second line that passes through the center of the substrate (40) and extends parallel to the scanning direction.

4. The exposure apparatus according to any preceding claim, wherein said one or more reference marks (200) comprises a plurality of reference marks (200), the reference marks (200) being spaced apart from each other in a direction perpendicular to the scanning direction.

5. An exposure method using the exposure apparatus according to one of claims 1 to 4, wherein a shot area to be exposed last on the substrate (40) is on the side opposite to the one of said one or more reference marks (200) that is measured immediately before exposure with respect to the first line.

6. The exposure method according to claim 5, wherein a shot area to be exposed first on the substrate (40) is on the same side as the one of said one or more reference marks (200) that is measured immediately before exposure with respect to the first line.

7. An exposure method for a scanning immersion exposure apparatus (1) including a projection optical system (30), a stage (45) configured to move with a substrate (40) mounted thereon, and liquid supply means configured to supply liquid to a local area between the projection optical system (30) and the stage (45) and recover the supplied liquid, the stage (45) including a delivery/receiving portion for delivering the local area in contact with the liquid from the stage (45) to a further stage (45b) and receiving said area from said another member, the method comprising the steps of:
setting a shot area to be exposed first on the substrate (40) and a shot area to be exposed last on the substrate (40) on the same side as the delivery/receiving portion with respect to a line that passes through the center of the substrate (40) and extends perpendicular to the scanning direction; and
exposing the substrate (40) on the basis of the set shot areas.

8. Use of an exposure apparatus as claimed in any one of claims 1 to 4 in a device manufacturing method.

## Patentansprüche

1. Scanimmersionsbelichtungsvorrichtung (1), umfassend:
eine Projektionsoptik (30);
einen Tisch (45), der konfiguriert ist, um sich mit einem auf ihm angebrachten Substrat (40) zu bewegen; und
eine Flüssigkeitszuführeinrichtung (110), die konfiguriert ist, um einem lokalen Bereich zwischen der Projektionsoptik (30) und dem Tisch (45) Flüssigkeit zuzuführen und die zugeführte Flüssigkeit zurückzugewinnen,
wobei der Tisch (45) enthält
einen Transferabschnitt (43), der konfiguriert ist, um den mit der Flüssigkeit in Kontakt befindlichen lokalen Bereich in die Lage zu versetzen, vom Tisch (45a) zu einem weiteren Tisch (45b) bewegt zu werden, und
eine oder mehrere auf dem Tisch (45) vorgesehene Referenzmarkierungen (200) zum Positionieren des Tisches (45) bezüglich einer Maske (20), **dadurch gekennzeichnet, dass**
im Betrieb die Scanimmersionsbelichtungsvorrichtung derart ausgebildet ist, dass der Transferabschnitt (43a) und eine direkt vor der Belichtung gemessene Referenzmarkierung (200Ra) der einen oder mehreren Referenzmarkierungen an gegenüberliegenden Seiten einer ersten Linie angeordnet sind, die durch das Zentrum des Substrats (40) verläuft und sich senkrecht zu einer Scanrichtung erstreckt.

2. Belichtungsvorrichtung nach Anspruch 1, wobei der Tisch (45) weiter einen Aufnahmeabschnitt (42) zum Aufnehmen des Bereichs von einem weiteren Mittel enthält, und
wobei der Aufnahmeabschnitt (42) bezüglich der ersten Linie auf derselben Seite wie eine direkt nach Aufnahme des Bereichs gemessene Referenzmarkierung der einen oder mehreren Referenzmarkierungen (200) angeordnet ist.

3. Belichtungsvorrichtung nach Anspruch 2, wobei der Aufnahmeabschnitt (42) bezüglich einer zweiten Linie, die durch das Zentrum des Substrats (40) verläuft und sich parallel zur Scanrichtung erstreckt, auf derselben Seite wie die direkt nach Aufnahme des Bereichs gemessene Referenzmarkierung der einen oder mehreren Referenzmarkierungen (200) angeordnet ist.

4. Belichtungsvorrichtung nach einem der vorhergehenden Ansprüche, wobei die eine oder mehreren Referenzmarkierungen (200) mehrere Referenzmarkierungen (200) umfassen, wobei die Referenzmarkierungen (200) in einer Richtung senkrecht zur Scanrichtung voneinander beabstandet sind.

5. Belichtungsverfahren, das die Belichtungsvorrichtung nach einem der Ansprüche 1 bis 4 verwendet, wobei sich ein als letztes zu belichtender Belichtungsbereich auf dem Substrat (40) bezüglich der ersten Linie auf der Seite gegenüber der einen direkt vor der Belichtung gemessenen Referenzmarkierung der einen oder mehreren Referenzmarkierungen (200) befindet.

6. Belichtungsverfahren nach Anspruch 5, wobei sich ein als erstes zu belichtender Belichtungsbereich auf dem Substrat (40) bezüglich der ersten Linie auf derselben Seite wie die eine direkt vor der Belichtung gemessene Referenzmarkierung der einen oder mehreren Referenzmarkierungen (200) befindet.

7. Belichtungsverfahren für eine Scanimmersionsbelichtungsvorrichtung (1) enthaltend eine Projektionsoptik (30), einen Tisch (45), der konfiguriert ist, um sich mit einem auf ihm angebrachten Substrat (40) zu bewegen, und eine Flüssigkeitszuführeinrichtung, die konfiguriert ist, um einem lokalen Bereich zwischen der Projektionsoptik (30) und dem Tisch (45) Flüssigkeit zuzuführen und die zugeführte Flüssigkeit zurückzugewinnen, wobei der Tisch (45) einen Transfer-/Aufnahmeabschnitt enthält, um den mit der Flüssigkeit in Kontakt befindlichen lokalen Bereich vom Tisch (45) zu einem weiteren Tisch (45b) zu transferieren, und den Bereich von einem weiteren Mittel aufzunehmen, wobei das Verfahren folgende Schritte umfasst:
Einrichten eines als erstes zu belichtenden Belichtungsbereichs auf dem Substrat (40) und eines als letztes zu belichtenden Belichtungsbereichs auf dem Substrat (40) auf derselben Seite wie den Transfer-/Aufnahmeabschnitt bezüglich einer Linie, die durch das Zentrum des Substrats (40) verläuft und sich senkrecht zur Scanrichtung erstreckt; und
Belichten des Substrats (40) auf der Grundlage der eingerichteten Belichtungsbereiche.

8. Verwendung einer Belichtungsvorrichtung nach einem der Ansprüche 1 bis 4 in einem Device-Herstellungsverfahren.

## Revendications

1. Appareil d'exposition par immersion à balayage (1), comprenant :
un système optique de projection (30) ;
un plateau (45) configuré pour se déplacer avec un substrat (40) monté sur celui-ci ; et
un moyen d'alimentation de liquide (110) configuré pour alimenter en liquide une zone locale entre le système de projection (30) et le plateau (45) et récupérer le liquide introduit,
dans lequel le plateau (45) comporte :
une partie d'introduction (43) configurée pour permettre de déplacer la zone locale en contact avec le liquide du plateau (45a) vers un autre plateau (45b), et
un ou plusieurs repères de référence (200) prévus sur le plateau (45) pour positionner le plateau (45) par rapport à un réticule (20), **caractérisé en ce que** :
lors de l'utilisation, l'appareil d'exposition par immersion à balayage est conçu de façon que la partie d'introduction (43a) et l'un desdits un ou plusieurs repères de référence (200Ra) mesurés immédiatement avant l'exposition soient disposés sur des côtés opposés d'une première droite passant par le centre du substrat (40) et s'étend perpendiculairement à une direction de balayage.

2. Appareil d'exposition selon la revendication 1, dans lequel le plateau (45) comporte en outre une partie de réception (42) destinée à recevoir ladite zone en provenance dudit autre élément, et
dans lequel la partie de réception (42) est disposée du même coté que l'un desdits un ou plusieurs repères de référence (200), qui est mesuré immédiatement après réception de ladite zone par rapport à la première droite.

3. Appareil d'exposition selon la revendication 2, dans lequel la partie de réception (42) est disposée du même côté que l'un desdits un ou plusieurs repères de référence (200), qui est mesuré immédiatement après réception de ladite zone par rapport à une seconde droite qui passe par le centre du substrat (40) et s'étend parallèlement à la direction de balayage.

4. Appareil d'exposition selon l'une quelconque des revendications précédentes, dans lequel lesdits un ou plusieurs repères de référence (200) comprennent une pluralité de repères de référence (200), les repères de référence (200) étant espacés les uns des autres dans une direction perpendiculaire à la direction de balayage.

5. Procédé d'exposition utilisant l'appareil d'exposition selon l'une des revendications 1 à 4, dans lequel une zone de visée devant être exposée en dernier sur le substrat (40) se trouve du côté opposé à l'un desdits un ou plusieurs repères de référence (200), qui est mesuré immédiatement avant exposition par rapport à la première droite.

6. Procédé d'exposition selon la revendication 5, dans lequel une zone de visée devant être exposée en premier sur le substrat (40) se trouve du même côté que l'un desdits un ou plusieurs repères de référence (200), qui est mesuré immédiatement avant exposition par rapport à la première droite.

7. Procédé d'exposition destiné à un appareil d'exposition par immersion à balayage (1) comportant un système optique de projection (30), un plateau (45) configuré pour se déplacer avec un substrat (40) monté sur celui-ci, et un moyen d'alimentation de liquide (110) configuré pour alimenter en liquide une zone locale entre le système optique de projection (30) et le plateau (45) et récupérer le liquide alimenté, le plateau (45) comportant une partie d'introduction/réception destinée à introduire la zone locale en contact avec le liquide du plateau (45a) vers un autre plateau (45b) et à recevoir ladite zone en provenance dudit autre élément, le procédé comprenant les étapes consistant à :
positionner une zone de visée devant être exposée en premier sur le substrat (40) et une zone de visée devant être exposée en dernier sur le substrat (40) du même côté que la partie d'introduction/réception par rapport à une droite qui passe par le centre du substrat (40) et s'étend perpendiculairement à la direction de balayage ; et
exposer le substrat (40) sur la base des zones de visée positionnées.

8. Utilisation d'un appareil d'exposition selon l'une quelconque des revendications 1 à 4, dans un procédé de fabrication de dispositifs.
